# EUROPEAN PATENT SPECIFICATION

(11) **EP 2 816 565 B1**
(45) Date of publication and mention of the grant of the patent: **11.09.2019**
(21) Application number: 12868602.9
(22) Date of filing: 22.02.2012
(51) Int. Cl.: G21C 15/00, F22B 37/54, F22B 1/02, F22B 37/20, F22B 37/48, G21D 1/00, C23F 11/00, F28F 19/06, F28F 19/00, F28D 7/06, C23C 16/50, C23F 14/02, F01K 5/02

(54) **SLUDGE-REDUCTION STEAM GENERATOR**
SCHLAMMREDUZIERENDER DAMPFERZEUGER
GÉNÉRATEUR DE VAPEUR DE RÉDUCTION DES BOUES

(30) Priority: 15.02.2012 KR 20120015321
(43) Date of publication of application: 24.12.2014
(73) Proprietor: Korea Hydro Nuclear Power Co., Ltd., Gyeongju-si, Gyeongsangbuk-do 780-010 (KR)
(72) Inventor: KIM, Han Sang, Daejeon-si 305-330 (KR)
(74) Representative: Hirsch & Associés
(86) International application number: PCT/KR2012/001332
(87) International publication number: WO 2013/122277

(56) References cited:
- EP-A1- 2 395 130
- WO-A1-93/07100
- FR-A1- 2 748 099
- JP-A- H07 256 365
- JP-A- 2008 007 851
- JP-A- 2008 545 114
- KR-A- 20060 123 474
- KR-B1- 0 138 714

## Description

### [Technical Field]

The present invention relates to a sludge-reduction steam generator, with which sludge deposits from the inside of said steam generator, specifically a steam generator of a pressurized light water reactor, can easily be removed.

### [Background Art]

A pressurized light water reactor nuclear power plant produces electric power through the steps of transferring heat generated from nuclear fuel, heating water supplied from the secondary side to convert the water into steam and carrying out mechanical work in a turbine using steam.

A great deal of supplied water containing corrosion products of a system structure causes a phase change in the secondary side of the steam generator, and in this instance, the iron corrosion products contained in the supplied water are deposited in the lower part of the secondary side of the steam generator due to a low speed of a flow rate.

The iron corrosion products are composed of 95.8% of hematite (Fe₂0₃) and magnetite (Fe₃0₄) and metallic oxides, and such iron corrosion products promote corrosion of a heat transfer pipe of the steam generator. Especially, the iron corrosion products which are deposited on a heat transfer pipe supporting plate (tubular pipe) obstruct a flow channel of cooling water so as to cause oscillation of a water level of the steam generator, and hence, cause power-reduction operation or an unexpected stop of a nuclear power plant.

Hundreds of kilograms of such iron corrosion products are deposited in the lower part of the steam generator every year. Therefore, in order to remove the corrosion products deposited in the lower part of the steam generator, a steam generator blow-down system is operated to remove the corrosion products at the time of an overhaul, but it has a problem in that the corrosion products are not easily removed by the blow-down system because iron oxide is fixed on the floor of the steam generator.

Moreover, recently, a measure to prevent the iron corrosion products from being deposited in the lower part of the steam generator using a dispersing agent has been effectively used, but it also has several problems in that using the dispersing agent requires high costs and causes side effects of water pollution.

Document FR 2 748 099 A1 discloses the repulsion of deposits by a chromium layer. Document EP 2 395 130 A1 discloses the use of a ceramic layer for the same purpose.

### [Disclosure]

### [Technical Problem]

Accordingly, the present invention has been made in an effort to solve the above-mentioned problems occurring in the prior arts, and it is an object of the present invention to provide a sludge-reduction steam generator based on a method for manufacturing a tubular plate for a sludge-reduction steam generator which can remarkably enhance a removal efficiency of corrosion products of a blow-down system of a steam generator in order to prevent deposition of iron corrosion products onto a tubular plate.

### [Technical Solution]

To achieve the above objects, the present invention provides a sludge-reduction steam generator including all features of independent claim 1, comprising inter alia: a plurality of U-shaped heat transfer pipes disposed in such a way that heat-exchange hot water flows in a pressure container; and one or more tubular plates penetrated by and coupled to the heat transfer pipes so as to support the heat transfer pipes, wherein the tubular plates are provided with a coated layer which is coated with a ceramic material having the same surface electrokinetic polarity (zeta potential) as iron corrosion products in a predetermined range.

Associated with the invention, as defined by the appended independent claim, is a method for manufacturing tubular plates supporting a plurality of U-shaped heat transfer pipes, which are disposed in such a way that heat-exchange hot water flows in a pressure container, the method for manufacturing tubular plates for a sludge-reduction steam generator including the step of: coating a coated layer on the surface of the tubular plates which are completely molded by coating a ceramic material having the same surface electrokinetic polarity (zeta potential) as iron corrosion products in a predetermined range.

The coated layer is coated on the surface of the tubular plates which support the heat transfer pipes of the steam generator by the chemical vapor deposition (CVD) or the plasma vapor deposition.

The ceramic material is one of titanium ceramic (TiO₂) and zirconium ceramic (ZrO₂).

### [Advantageous Effects]

The sludge-reduction steam generator according to the invention, as defined by the appended independent claim 1, and the associated method for manufacturing the tubular plate for the sludge-reduction steam generator can provide an effect that the coated layer made of titanium ceramic (TiO₂) or zirconium ceramic (ZrO₂) coated on the upper side of the heat transfer pipe supporting plates (tubular plate) below the steam generator prevents deposition of Fe₂0₃ and Fe₃0₄ which are the main ingredients of sludge of the secondary side of the steam generator and increases surface induction to thereby easily remove iron corrosion products by a blow-down system of the steam generator.

Furthermore, the sludge-reduction steam generator and the method for manufacturing the tubular plate for the sludge-reduction steam generator can reduce blocking of a flow channel of the steam generator, reduce fouling of the heat transfer pipes of the steam generator and increase thermal efficiency through the effective removal of sludge of the steam generator.

Additionally, the sludge-reduction steam generator and the method for manufacturing the tubular plate for the sludge-reduction steam generator can reduce a damage of the heat transfer pipes in the heat transfer pipe supporting plates (tubular plates) by the sludge.

In addition, sludge-reduction steam generator and the method for manufacturing the tubular plate for the sludge-reduction steam generator can prevent corrosion of a gap between a tube of the steam generator and a tube seat to thereby increase the lifespan of the heat transfer pipes of the steam generator.

### [Description of Drawings]

FIG. 1 is a sectional view of a steam generator 1 according to a preferred embodiment of the present invention.
FIG. 2 is a plan view of a heat transfer pipe supporting plate (tubular plate) 3 cut along the line of I-I of FIG. 1.
FIG. 3 is a schematic sectional view of the tubular plate 3 having a ceramic coated later 30.

### [Mode for Invention]

Reference will be now made in detail to the preferred embodiment of the present invention with reference to the attached drawings. The present invention is defined solely by the subject-matter of the appended independent claim.

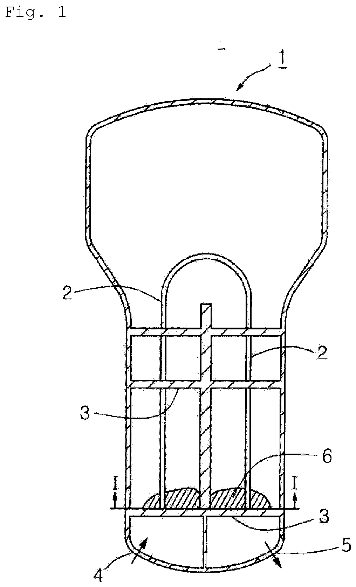

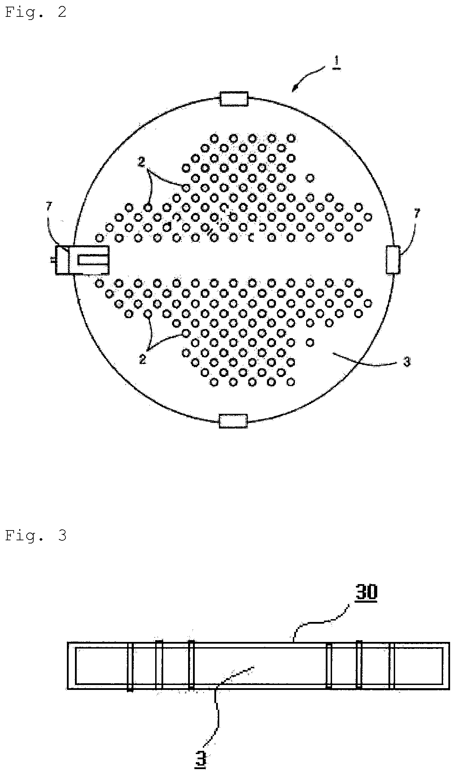

FIG. 1 is a sectional view of a steam generator 1 according to a preferred embodiment of the present invention, FIG. 2 is a plan view of a heat transfer pipe supporting plate (tubular plate) 3 cut along the line of I-I of FIG. 1, and FIG. 3 is a schematic sectional view of the tubular plate 3 having a ceramic coated later 30.

As shown in FIGS. 1 and 2, the sludge-reduction steam generator 1 includes: a plurality of U-shaped heat transfer pipes 2 disposed in such a way that heat-exchange hot water may flow in a pressure container; and one or more tubular plates 3 penetrated by and coupled to the heat transfer pipes 2 so as to support the heat transfer pipes 2, wherein the tubular plates 3, as shown in FIG. 3, are provided with a coated layer 30 which is coated with a ceramic material having the same surface electrokinetic polarity (zeta potential) as iron corrosion products in a predetermined range.

The pressurized container includes: a plurality of inlets 4 for introducing heated water thereinto; a plurality of outlets 5 for discharging water which moves through the heat transfer pipes 2 and is cooled after carrying out heat exchange; and a plurality of blow down ports 7 for removing deposits 6.

The ceramic material is one of titanium ceramic (TiO₂) and zirconium ceramic (ZrO₂).

The ceramic coated layer 30 is formed in such a way that TiO₂ or ZrO₂ which is a material existing stably in the high-temperature and high-pH environment of the secondary side of the steam generator is coated on the surface of the tubular plates 3 which support the heat transfer pipes 2 of the steam generator 1 by the chemical vapor deposition (CVD) or the plasma vapor deposition.

The secondary side of the steam generator 1 is operated under the high-temperature, high-pressure and high-pH environment. Therefore, an operation range of an electrochemical potential (ECP) may be varied from (+) tens of mVs to (-) 500mVs. The zeta potential of Fe₂0₃ and Fe₃0₄ under temperature and pH for operating a general steam generator 1 is about -4mVs, and TiO₂ or ZrO₂ under the same temperature and pH conditions has the same structure and similar potential.

The ceramic coated layer 30 is made of a material which can endure the change range of the ECP and the temperature change inside the steam generator 1 for a long time, and has the same polarity as magnetite of which zeta potential exists in a colloid state inside a dendrogram.

Therefore, the ceramic coated layer 30 which is made of TiO₂ or ZrO₂ causes electrically repulsive power against the deposits containing Fe₂0₃ and Fe₃0₄. Accordingly, because friction force between the surface of the coated layer 30 and the deposits is reduced, the ceramic coated layer 30 increases surface mobility of the deposits which are iron-containing foreign matters to thereby induce the deposits to be easily removed through the blow down ports 7 of the steam generator 1. Therefore, corrosion product removal efficiency of the blow down system of the steam generator is also remarkably enhanced.

## Claims

1. A sludge-reduction steam generator (1) comprising:
a plurality of U-shaped heat transfer pipes (2) disposed in such a way that heat-exchange hot water flows in a pressure container; and
one or more tubular plates (3) coupled to the heat transfer pipes (2) so as to support the heat transfer pipes (2),
upper surfaces of the tubular plates (3) being provided with a coated layer (30),
wherein the coated layer (30) is coated with a ceramic material having the same surface electrokinetic potential (zeta potential) as iron corrosion products including magnetite contained in sludge deposits (6) and generating electric repulsion with precipitates including Fe₂O₃ and Fe₃O₄, and the ceramic material is one of titanium ceramic including TiO₂ and zirconium ceramic including ZrO₂ and
wherein the sludge-reduction steam generator (1) comprises a plurality of blow down ports (7) for easily removing the sludge deposits (6).

## Patentansprüche

1. Schlammreduktionsdampferzeuger (1), umfassend:
eine Vielzahl von U-förmigen Wärmeübertragungsrohren (2), die derart angeordnet sind, dass in einem Druckbehälter wärmeaustauschendes heißes Wasser fließt; und
eine oder mehrere rohrförmige Platten (3), die mit den Wärmeübertragungsrohren (2) verbunden sind, um die Wärmeübertragungsrohre (2) zu tragen,
die oberen Oberflächen der rohrförmigen Platten (3) mit einer Überzugsschicht (30) versehen sind,
wobei die Überzugsschicht (30) mit einem Keramikmaterial beschichtet ist, das das gleiche elektrokinetische Oberflächenpotential (Zeta-Potential) wie Eisenkorrosionsprodukte aufweist, einschließlich Magnetit, die in Schlammablagerungen (6) enthalten sind, und eine elektrische Abstoßung mit Präzipitaten, einschließlich Fe₂O₃ und Fe₃O₄, und das Keramikmaterial ist eine Titankeramik einschließlich TiO₂ und Zirkonkeramik einschließlich ZrO₂ und
wobei der Schlammreduktionsdampferzeuger (1) mehrere Abblasöffnungen (7) aufweist, um die Schlammablagerungen (6) leicht zu entfernen.

## Revendications

1. Générateur de vapeur réduisant les boues (1) comprenant :
une pluralité de tuyaux de transfert de chaleur en forme de U (2) disposés de manière à ce que de l'eau chaude échangeuse de chaleur s'écoule dans un récipient sous pression; et
une ou plusieurs plaques tubulaires (3) couplées aux tuyaux de transfert de chaleur (2) afin de supporter les tuyaux de transfert de chaleur (2),
les surfaces supérieures des plaques tubulaires (3) étant pourvues d'une couche portant un revêtement (30),
dans lequel la couche revêtue (30) est recouverte d'un matériau céramique ayant le même potentiel électrocinétique de surface (potentiel zêta) que les produits de corrosion du fer, y compris la magnétite, contenus dans les dépôts de boues (6), et générant une répulsion électrique avec des précipités comprenant Fe₂O₃ et Fe₃O₄, et le matériau céramique est l'un parmi la céramique de titane, y compris le TiO₂ et la céramique de zirconium, y compris le ZrO₂, et
dans lequel le générateur de vapeur réduisant les boues (1) comprend une pluralité d'orifices de soufflage (7) permettant d'éliminer facilement les dépôts de boues (6).
